# EUROPEAN PATENT SPECIFICATION

(11) **EP 2 255 384 B1**
(45) Date of publication and mention of the grant of the patent: **20.11.2019**
(21) Application number: 09712940.7
(22) Date of filing: 20.02.2009
(51) Int. Cl.: H01L 21/683, H01L 21/68, H01L 31/04, H01L 21/20, H01L 21/677

(54) **CERAMIC PADDLE**
KERAMIK-PADDLE
PALETTE DE CÉRAMIQUE

(30) Priority: 21.02.2008 US 30397 P
(43) Date of publication of application: 01.12.2010
(73) Proprietor: Saint-Gobain Ceramics & Plastics, Inc., Worcester, MA 01615-0138 (US)
(72) Inventor: KAEMPFE, Scott A., Brighton Massachusetts 02135 (US); KENNEY, Michael P., Charlton Massachusetts 01507 (US); DWYER, Karen A., Sterling Massachusetts 01564 (US); ZHANG, Peng, Northborough Massachusetts 01532 (US)
(74) Representative: Zimmermann & Partner Patentanwälte mbB
(86) International application number: PCT/US2009/034667
(87) International publication number: WO 2009/105635

(56) References cited:
- JP-A- 3 250 625
- JP-A- 4 098 827
- JP-A- 63 254 723
- JP-B- 6 018 178
- US-A- 3 951 587
- US-A- 5 776 391
- US-B1- 6 631 934
- US-B1- 6 631 934

## Description

### BACKGROUND

### 1. Field of Invention

The invention relates to ceramic paddles for use in semiconductor wafer production and, in particular, to ceramic paddles for processing photovoltaic wafers.

### 2. Discussion of Related Art

The processing of semiconductor wafers, including photovoltaic wafers, often requires high temperature treatment of the wafers in a controlled atmosphere. Processing can include the deposition of materials onto wafers by, for example, chemical vapor deposition (CVD) techniques. For instance, photovoltaic cells may be doped with phosphorous or boron at high temperatures.

Current production furnaces are typically cylindrical and have a diameter of about 300 mm. During production, it is important that wafers or support devices do not touch the sides of the furnace. Thus, cantilever paddles can be used to slide boats of wafers into and out of the furnace. One example of a cantilever paddle is described in United States Patent No. 6,631,934 titled "Silicon Carbide Cantilever Paddle". The paddle may include a carrier zone and a handle that includes a large diameter section with a square cross-section of approximately 2 inches per side. JP 4 098827 A describes a processing fork comprising a loading part which is hollow-structured to lessen the dead weight while reducing the bend of the processing fork.

### SUMMARY

The subject matter of this application may involve, in some cases, interrelated products, alternative solutions to a particular problem, and/or a plurality of different uses of a single system or article.

In one aspect, a wafer paddle is provided, the paddle comprising a handle and a double-walled load zone constructed and arranged to support a plurality of wafers, the load zone having a cross-section that includes an upper wall portion and a lower wall portion wherein the upper wall portion defines a central channel that has a depth that is at least 30% of the height of the load zone.

In another aspect a method of processing a wafer is provided, the method comprising the steps of loading greater than 20 kg of wafers onto a silicon carbide wafer paddle having a five cm handle and exhibiting a deflection of less than 20 mm under a load of greater than 20 kg, sliding the paddle into a furnace tube, and processing the wafers.

In another aspect a cantilever ceramic wafer paddle is provided, the paddle comprising a double-walled load zone and a handle having a cross-sectional area of less than 56 cm².

In another aspect a method is provided, the method comprising steps of loading greater than 20 kg of semiconductor wafers onto a wafer paddle in a diamond load configuration, deflecting the paddle by less than 20 mm under the 20 kg load, sliding the paddle into a processing furnace, and processing the wafers.

In another aspect, a cantilever wafer processing paddle of length greater than 2000 mm is provided wherein the vertical deflection at the proximal end of the load zone is less than 20 mm when the handle is clamped and a load of greater than 25 kg is distributed over the load zone of the paddle.

In another aspect, a wafer paddle is provided, the paddle comprising a handle and a double-walled load zone constructed and arranged to support a plurality of wafers, the load zone having a double-walled structure that includes an upper wall portion and a lower wall portion wherein the upper wall portion defines a slot substantially aligned with a longitudinal axis of the paddle.

In another aspect, a wafer paddle is provided, the paddle comprising a handle and a double-walled load zone constructed and arranged to support a plurality of wafers, the load zone having a double-walled structure that includes an upper wall portion and a lower wall portion wherein the lower wall portion defines at least one thermal window.

In another aspect, a method of inserting and removing a loaded wafer paddle without damaging the structure of the paddle is provided, the method comprising loading a paddle with greater than 20 kg of silicon wafers, inserting the loaded paddle into a furnace, and removing the loaded paddle from the furnace at a rate of greater than 300 mm/min wherein the furnace is at a temperature greater than or equal to 700° C.

In another aspect, a method of inserting and removing a loaded wafer paddle without damaging the structure of the paddle is provided, the method comprising loading a paddle with greater than 20 kg of silicon wafers, inserting the loaded paddle into a furnace at a rate of greater than 300 mm/min wherein the furnace is at a temperature greater than or equal to 700° C, and removing the loaded paddle from the furnace.

In another aspect, an apparatus is provided, the apparatus comprising a silicon carbide wafer paddle including a handle and a double-walled load zone and at least one long boat or two half boats positioned on the load zone, the boat or boats supporting a plurality of semiconductor wafers, wherein the load zone extends at least 50 mm beyond the distal end of the boat or boats.

### BRIEF DESCRIPTION OF THE DRAWINGS

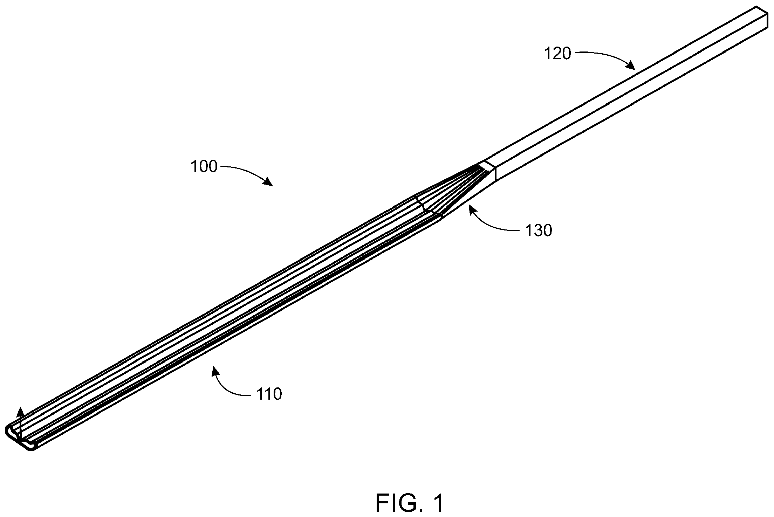

In the drawings, FIG. 1 is a perspective drawing of one embodiment of a cantilever paddle;
FIG. 2 is an end view of the handle of the paddle of FIG. 1;
FIG. 3a is an end view of the load zone of the paddle of FIG. 1;
FIGS. 3b and 3c provide cross-sectional views of the load zone of different embodiments;
FIG. 4 is an end view of a loaded boat on the paddle of FIG. 1;
FIG. 5 is an isometric view of one embodiment of a system;
FIG. 6 is a side view of the embodiment shown in FIG. 5;
FIG. 7 is an isometric view of one embodiment of a paddle;
FIG. 8 is an isometric view of another embodiment of a paddle;
FIG. 9 is a table displaying test results: and
FIG.10 is a graph comparing stress results from 5 different paddle embodiments.

### DETAILED DESCRIPTION

In one aspect, a ceramic paddle for the processing of semiconductor wafers is described. Processing includes treatment that changes the chemical or physical properties of the wafer and includes, for example, doping and oxidation processes. The wafers may be, for example, photovoltaic wafers. The paddle may be made partially or entirely of silicon carbide (SiC) and may be coated with a chemical vapor deposition (CVD) layer of SiC or other material. Silicon carbide includes forms of this material used in the art such as sintered SiC, recrystallized SiC, and silicon infiltrated SiC. The paddle can be loaded directly with wafers or the wafers may receive intermediate support by placement in a boat or boats. One, two, three, four, five or more boats may be used on a single paddle. For instance, the wafers may be supported by long boats or intermediate carriers (half boats). In some embodiments, the paddle can support more than 20 kg, more than 25 kg or more than 30 kg with a deflection of less than 20 mm at the distal end of the paddle. In other embodiments, the deflection may be less than 30 mm, less than 25 mm or less than 15 mm at similar loads with a load zone longer than 1500 mm. The paddle may be a cantilevered paddle in that it is supported only at the handle by a clamp. The paddle may be used with a horizontal furnace and may be transported horizontally into and out of the furnace. The designs described herein may be capable of being inserted into and removed from a 700°C (or greater) furnace, fully loaded, at rates of greater than 300 mm/min, 400 mm/min or 500 mm/min, without causing any structural damage to the paddle.

In another aspect, the paddle may include three sections referred to as the handle, the transition zone and the load zone. Some paddles may not include a transition zone but may join the load zone directly to the handle. Each section may be of a different length although the load zone is typically the longest and the transition zone the shortest. The handle may be of any shape and its cross section can be round, square, rectangular, ovoid or polygonal. In one set of embodiments, the handle is hollow and square with rounded corners. A "substantially square" component is one that has four equal length sides at 90 degrees to each other but in which the corners may be rounded. A "substantially rectangular" component is one that has two pairs of parallel sides at 90 degrees to each other but in which the corners may be rounded. In some embodiments, the handle may have a cross-sectional area of less than 100 cm², less than 58 cm², less than 40 cm² or less than 30 cm². The handle may be dimensioned to fit into a conventional clamp and therefore may be, in cross-section, a two inch by two inch (5 x 5 cm) square or a three inch by three inch (7.5 x 7.5 cm) square. During processing, a clamp may secure the handle at various distances from the end of the handle. For instance, the clamp may secure greater than 5 cm, greater than 10 cm, greater than 25 cm or greater than 50 cm of the proximal end of the handle.

The load zone of the paddle may be double walled. As used herein, double walled refers to a component that in cross section has a continuous wall surrounding a hollow portion. The continuous wall may be of a regular or irregular cross-sectional shape and may be of consistent or variable thickness throughout the cross-section or along the length of the component. The paddle may be hollow along a portion or all of its length and, if hollow, may include a dam for preventing air flow through the paddle.

In some embodiments, the paddle is constructed and arranged to carry round or square wafers or both. In most embodiments wafers are positioned vertically and aligned parallel to each other with spacing in between. Photovoltaic wafers can be square and can be loaded in a diamond configuration or a square configuration. In square configuration the wafers are loaded with edges parallel to vertical and horizontal. In diamond configuration, the wafers are loaded with two corners aligned along a vertical midline so that one corner points downward. In some embodiments, the paddle can support square wafers in both a square and diamond configuration. A single paddle may support more than 100, 200, 400, 500 or 600 wafers. The wafers may be any shape such as square or round and may be of any size that can be processed in the chosen system. In one set of embodiments the wafers are 156 mm square wafers.

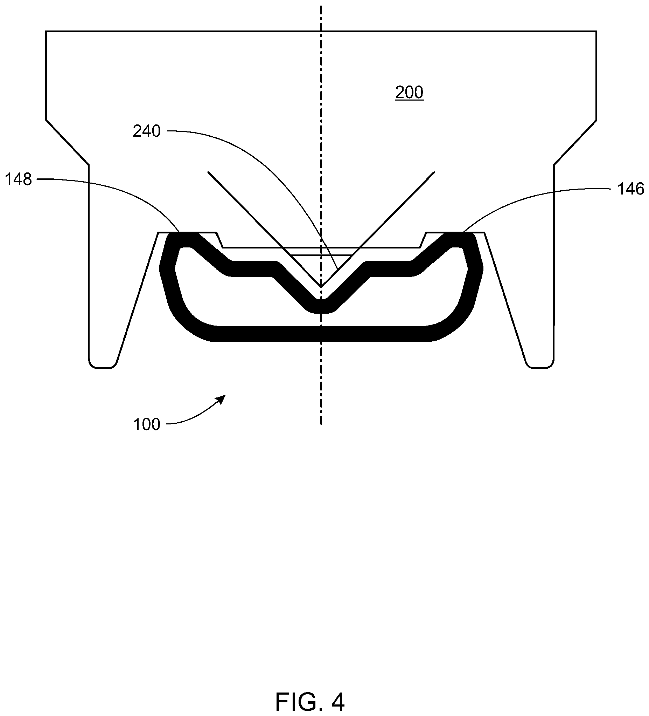

Wafers may be loaded into boats prior to placing the wafers on the paddle. When boats are used, the paddle supports the boat or boats and typically does not come in direct contact with the wafers that are held in the boat. Boats typically come in two sizes (although the paddle may be used with boats of any size). The smaller ones are referred to as "half boats" or "intermediate carriers." The larger ones are known as "long boats" or "full boats." Long boats typically carry twice the number of wafers as half boats and are about twice as heavy. For example, a loaded half boat may weigh 15 kg while a loaded long boat may weigh about 30 kg. Long boats and half boats usually have two pairs of feet, one pair at each end of the boat. The feet can support the boat while wafers are being loaded into the boat. There are usually shoulders above the feet that can rest on the upper surface of the paddle when the boat is transferred to the paddle. See FIG. 4. In many embodiments described herein, paddles are dimensioned to carry either a single long boat or two half boats. In this case, the paddle is subjected to either four (half boat) or two (long boat) weight bearing positions along the length of the load zone.

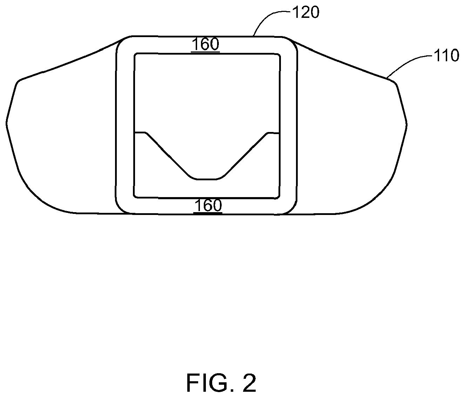

A perspective view of one embodiment of a silicon carbide cantilever paddle is shown in FIG. 1. Paddle 100 includes handle 120, transition zone 130 and load zone 110. Paddle length and the proportions of each paddle section can be directed by the system with which the paddle is intended to be used. For instance, the load zone can be sized for a particular number of wafers or boats that can be loaded at a particular density into a furnace. The transition zone may be sized, for instance, based on the difference in size and shape between the handle and the load zone. In various embodiments the handle may be greater than 500 mm long, greater than 750 mm long, or greater than 1000 mm long. The load zone may be, for example, greater than 800 mm, greater than 1000 mm, greater than 1500 mm or greater than 1600 mm long. The transition zone may be from 0 to 500 mm, or more, in length. The total length of the paddle embodiment shown in FIG. 1 is 2967 mm with the handle being 1093 mm long, the transition zone being 254 mm long and the load zone being 1620 mm long. The paddle can be made in a single casting using methods known to those skilled in the art. The handle is sized to be held by a clamp that surrounds the proximal 520 mm of the handle. An end view of the proximal end of handle 120 is provided in FIG. 2. The handle shown is substantially square and includes continuous wall 160 that has a thickness of about 4.8 mm. Its cross-sectional dimensions are five cm by five cm (2" by 2") and it is of consistent diameter throughout the length of the handle. Handle portions having cross-sectional dimensions of 7.5 cm by 7.5 cm (3" by 3") can also be used but a five cm (two inch) handle may be preferred. Many furnaces for the production of photovoltaic wafers include a door designed to seal around the paddle after insertion into the furnace to help maintain the controlled atmosphere in the furnace. A door for a five cm handle can be less than half the area of the door for a 7.5 cm handle. It also has a much smaller circumference. A smaller door can provide for less heat loss as well as less leakage of atmosphere into or out of the furnace. During wafer production, heat is also lost to the ambient environment via conduction through the handle. A smaller diameter handle is of less surface area and less mass than a 7.5 cm handle and thus provides for less conduction of heat through the handle as well as less convection and/or radiational cooling from the handle to the ambient environment.

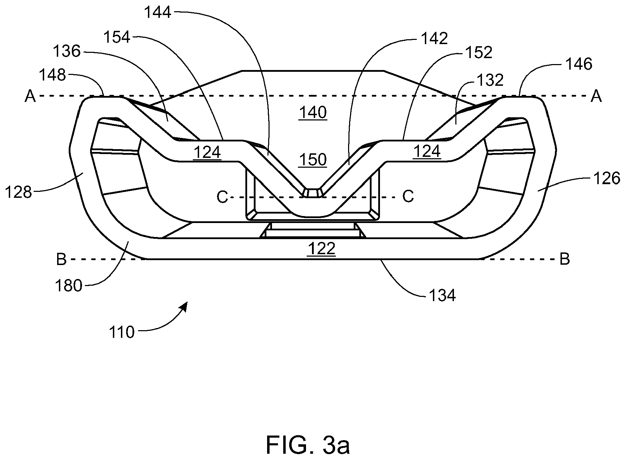

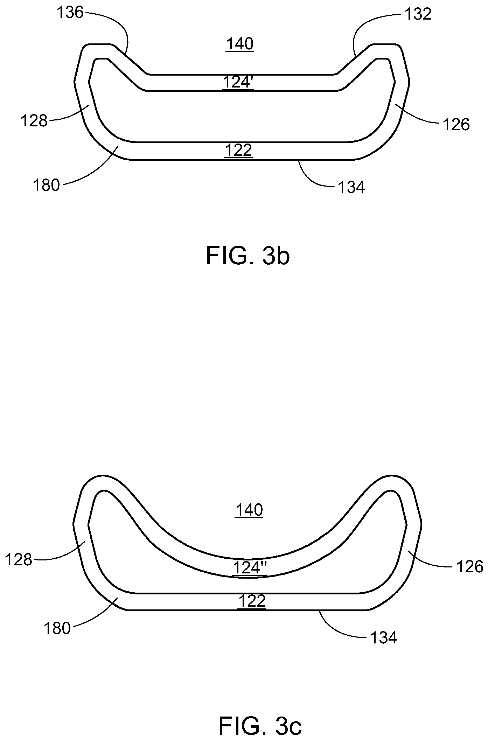

FIGS. 3a-c provide an end view of the distal portion of several embodiments of a load zone 110. Load zone 110 is cast with a single continuous wall 120 that has a thickness of about 4.8 mm. Continuous wall 120 can be divided into lower wall portion 122, side wall portions 126 and 128, and upper wall portion 124. Lower wall portion 122 includes bottom surface 134. Upper wall portion 124 can include a variety of surface features including flat horizontal surfaces 152 and 154, sloped surfaces 132 and 136 and contact points 146 and 148. One or more loaded boats 200 can be supported by load zone 110 and in one set of embodiments the shoulders of a boat are supported at upper paddle surfaces 146 and 148, as is shown FIG. 4. Wafer 240 is shown in a diamond load configuration. The height of the load zone is the distance from the contact points to the bottom surface and is represented by the distance from line A-A to line B-B in FIG. 3. This height can range, for example, from 2 cm to 10 cm, from 3 cm to 6 cm, and in one embodiment is 38.2 mm. The width of the load zone will be less than the width of the furnace with which it is used in order to avoid contact with the inner surface of the tube. In many embodiments the width of the load zone is less than that of the boat or boats that are being supported. For a 300 mm (actual diameter is about 342 mm) tube, the load zone may have a width of less than 250 mm, less than 200 mm or less than 180 mm. In one embodiment the width is 113.5 mm.

Upper wall portion 124 may include a channel 140 that encompasses the length of, or a portion of the length of, load zone 110. Channel 140, which may be centrally located on the cross-section of load zone 110, is defined by sloping wall portions 132 and 136 which can be straight, curved, polygonal, or any combination thereof. Straight wall portions may be angled at, for example, 15°, 30°, 45° or 60° from vertical. Polygonal or curved wall portions may increase gradually from a centrally located horizontal surface to vertically, or almost vertically, oriented side wall portions. Curved channels may exhibit various radii of curvatures throughout the cross-section of the channel. For example, a channel may exhibit a radius of curvature of greater than 2 cm, greater than 5 cm, greater than 10 cm or greater than 20 cm. It has been found that a greater radius of curvature can improve thermal and/or mechanical stress. Channel 140 can be sized to avoid interference with corners of square wafers (in diamond configuration) when boat 200 is supported by the paddle as shown in FIG. 4. Channel 140 can be any shape designed to provide clearance for the corner of a wafer and may be a single, continuous shape or may be a combination of cross-sectional shapes, as shown in FIG. 3. The depth of channel 140 is represented in FIG. 3a as the distance from line A-A to line C-C. This depth can be greater than 1 cm, greater than 2 cm, greater than 3 cm, greater than 4 cm or greater than 5 cm. When compared to the height of the load zone (A-A to B-B) the depth of channel 140 may be, for example, greater than or equal to 30%, 40%, 50%, 60% or 70% of the height. The ratio of the height of load zone 110 to the depth of channel 140 can be, for example, less than or equal to 3:1, 2:1, 3:2, or 5:4. In one set of embodiments, the depth of channel 140 is 23.4 mm. If the depth of the channel varies along the length of the load zone the "depth" is considered to be the average depth of the channel along its length. FIG. 3b illustrates a paddle with a load zone including a channel 140 that, in cross-section, is defined by sloping wall portions 132 and 136 as well as straight horizontal upper wall portion 124'. The embodiment shown in FIG. 3c includes a continuously curved upper wall portion 124". Other embodiments may include upper wall portions that, in cross-section, are a compilation of straight and curved sections. A load zone may also include a sub-channel 150, as shown in FIG. 3a. A sub-channel may be substantially V or U shaped and may be bounded by wall portions 142 and 144 which may be straight, curved, or some combination thereof. Wall portions 142 and 144 may be, for instance, 30 degrees, 45 degrees or 60 degrees from vertical. Sub-channel 150 can form part of channel 140 and may further increase the depth of channel 140. Sub-channel 150 may be specifically shaped to provide access for diamond-configured wafers.

When carrying wafers, a paddle is subjected to stress as a result of the load. The inventors believe that a preferred paddle should be strong enough to support a full complement of boats and wafers while at the same time exhibiting stiffness that results in a limited amount of deflection of the paddle. If the paddle bends too much under load there may be an increased risk of contacting the interior of the furnace with wafers, boats or the paddle when inserting materials into or withdrawing materials from the furnace. Paddle deflection is defined herein as the vertical drop of the distal tip of a cantilever paddle under a specific load when the paddle is retained in a clamp that secures the proximal 520 mm of the paddle handle.

Catastrophic failure of a paddle during wafer production can result in, for example, lost product, damaged production equipment and possibly injury. As a result, it can be helpful to know the maximum amount of stress that a specific paddle can withstand without failing. Predicted stress may vary due to, for example, unforeseen vertical acceleration of the load, thermal stresses in the furnace, or unconventional loading or unloading procedures. Due to these and other known and unknown causes of stress variance, a safety factor of 3X or 4X may be used in paddle design. For instance, if the maximum stress for a particular material of construction is 200 MPa, then a value of about ¼ of that value, or 50 MPa, may be chosen as the upper limit for stress that the paddle should see under the anticipated load. Once a design is finalized, the maximum stress that a paddle design will be subjected to can be determined using finite elemental analysis. The location of that maximum stress can also be determined.

Furnaces used to process photovoltaic wafers may exceed temperatures greater than 500 ºC. For instance, in some POCl₃ doping processes the furnace may be maintained at 800 to 1100 ºC. During processing, a paddle may reside in a furnace for a period of greater than 5, greater than 10 or greater than 30 minutes and therefore the paddle may be compatible with high temperatures for an extended length of time. While it may seem that the location of maximum stress is not important if the maximum stress value is not to be exceeded in practice, it can be advantageous to use a paddle in which the location of maximum stress is in the handle, an area that is not subjected to the same level of thermal stress as is the load zone. The handle may realize an increase in temperature when the paddle is in use, however the temperatures that the handle experiences will be significantly less than those seen by the load zone and transition zone. Thermal stresses and thermal cycling may in some cases reduce the maximum load stress that a paddle can withstand. The safety factor can help compensate for this but if the location of maximum stress is in the handle, this concern can be reduced or eliminated entirely. In this case, a reduced safety factor or, alternatively, a higher stress value, can be tolerated.

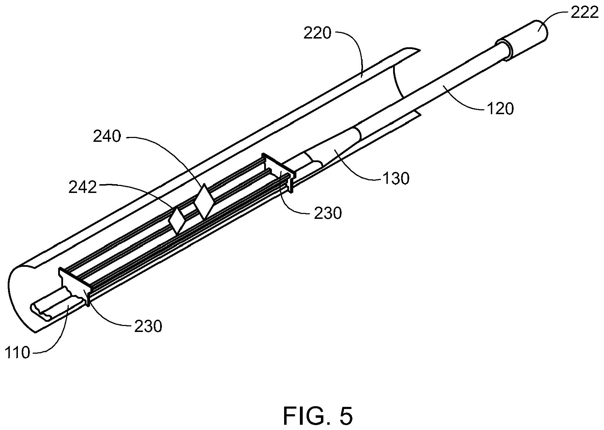

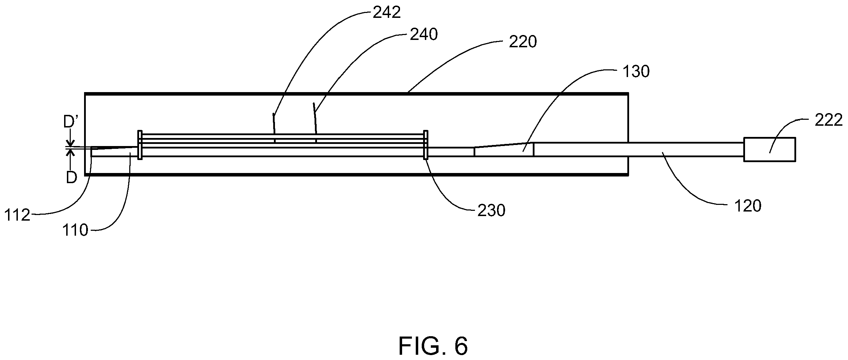

One embodiment of a system for processing photovoltaic wafers is provided in FIGS. 5 and 6. FIG. 5 provides an isometric view and FIG. 6 provides a side view that illustrates how deflection is measured. Paddle 100 is suspended in silicon carbide furnace 220 by clamp 222. Long boat 230 rests on load zone 110 and supports wafers 240 and 242 in a diamond load configuration. For clarity, two wafers are shown although typically several hundred, or more, are loaded simultaneously. The wafers are shown in a vertical arrangement although horizontal arrangements are possible as well. The wafers may be canted to one side or the other for stability. To measure or determine deflection, the load being evaluated is distributed across the load zone of a clamped paddle and the drop at the distal end of load zone 110 is measured. The difference in position of end 112 of the paddle between the unloaded state and the loaded state is the deflection and is shown in FIG. 6 as D-D'. In this case, the deflection is about 10 mm. A small amount of deflection and/or the ability to nest wafers on a paddle can help to minimize the dimensions of the furnace, resulting in reduced energy consumption and reduced variation of gas flow and temperature variation.

In another set of embodiments, a paddle may include one or more thermal windows, or simply "windows," in the lower wall portion of the paddle. A window can be an opening or void in the paddle wall that passes entirely through the wall, providing a pathway between the exterior and the interior of the paddle. Windows may be centrally located along the lower wall portion and may be in alignment with the longitudinal axis of the paddle. In many embodiments, windows may be sized to cover greater than 5%, greater than 10%, greater than 20% or greater than 30% of the surface area of the lower wall portion of the load zone. Multiple windows may be aligned with each other or may be staggered. Windows may be formed using methods known to those skilled in the art and can be, for example, molded into a paddle during initial casting or cut into the paddle at various stages of production. It has been found that windows can help to relieve the thermal stress on the paddle that can occur when the paddle is removed from the furnace. It is believed that one or more windows in the lower wall portion of the paddle can provide a pathway for improved cooling that can result in improved stress characteristics, a lower failure rate and longer life times. It is believed that heat in the upper wall portion of the paddle can radiate downward, passing through the window(s) in the lower wall portion, rather than being trapped or reflected back at the source. Windows have been shown to be particularly advantageous when disposed in the load zone of the paddle. In one set of embodiments, windows are positioned in areas of a paddle where the greatest thermal stresses are realized.

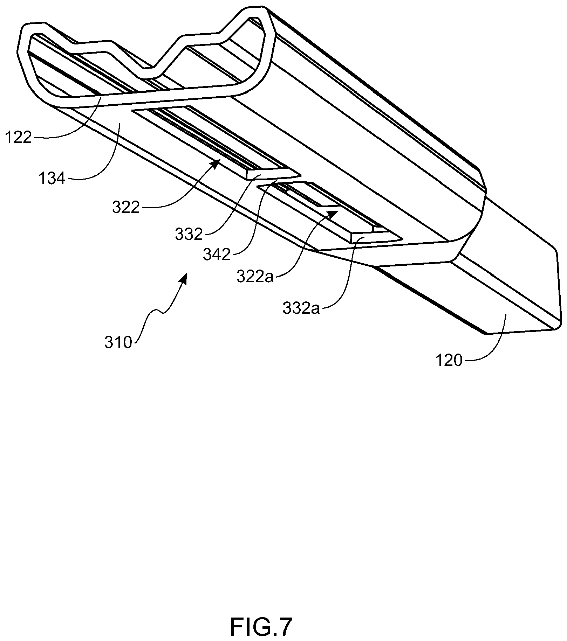

FIG. 7 provides an illustration of one particular embodiment that includes multiple windows. Paddle 310 is shown with two windows, 322 and 322a. The windows are defined by wall portions 332 and 332a and are separated by cross brace 342. Windows 322 and 322a pass entirely through lower wall portion 122. In some embodiments, windows may have a width that is greater than or equal to about 10%, 20%, 30%, 50% or 70% of the width of the load zone. The length of one or more windows, in some embodiments, may vary from several millimeters up to the length of the load zone or the length of the transition zone. It has been shown that the insertion of a window into a paddle design has only a very small effect on the deflection of the paddle. Therefore, a paddle can be made which is lighter and provides better cooling characteristics without a significant increase in deflection under anticipated loads.

In another set of embodiments one or more "slots" can be formed in the upper surface of the load zone of the paddle. A slot may pass entirely through the upper wall portion of a paddle and one or more slots can be positioned on a single load zone. Slots may be formed using methods known to those skilled in the art and can be, for example, molded into a paddle during initial casting or cut into the paddle at various stages of production. In many embodiments a slot can be positioned parallel to the longitudinal axis of the paddle and may have a length greater than its width. A slot may be centrally located and can be formed in a channel or sub-channel that is flat, curved or V-shaped. A slot may serve several purposes including providing space for the corners of wafers when in a diamond configuration and may also relieve stress that would otherwise concentrate in this central area. For example, a slot formed in the vertex of a V-shaped load zone has been shown to reduce stress that may otherwise be concentrated at this vertex.

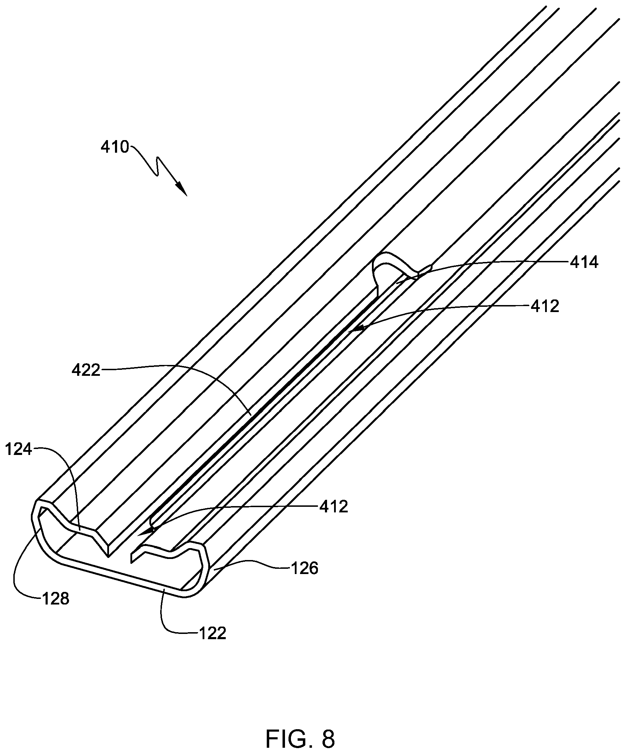

FIG. 8 provides an illustration of one embodiment of a paddle that includes a slot. Slot 412 extends from the distal end of the load zone (although this need not be the case) in paddle 410 to keyhole 414 (optional), also positioned in the load zone. Keyhole 414 may serve to distribute stress and provide a termination point for slot 412. Slot 412 is defined by wall portion 422 and passes entirely through upper wall portion 124. Wall portions 122, 126 and 128 may be unaffected. Slot 412 may provide for improved spacing and handling of wafers while also relieving stress in the upper wall portion of the load zone. In some embodiments, slots may have an average width that is greater than or equal to about 10%, 20%, 30%, 50% or 70% of the width of the load zone. In some embodiments slot width may be determined by calculating the space needed to provide sufficient room for wafers when a wafer boat is seated on the paddle. The length of one or more slots, in some embodiments, may vary from several millimeters up to the length of the load zone. Slots may be of consistent width or may vary in width along the length of the slot. Some embodiments may include both slots and windows in the same paddle.

In another set of embodiments the load zone may be extended so that, when loaded, the distal end of the load zone extends beyond the end of the boat and/or wafers by a distance equal to the length of the extension. The extension may be greater than or equal to 5 cm, 10 cm or 20 cm. In other embodiments, the length of the load zone may be extended by more than 5%, 7.5% or 10%. In many cases, a paddle with an extended load zone is designed to support the same load as other paddles described herein. For example, the paddle with an extended load zone may be loaded with two half boats or one long boat of wafers. The load zone extension has been shown to provide for improved thermal stress characteristics. For example, maximum thermal stress can be reduced by more than 5 or 10 percent. It is believed that, upon cooling, the extension can help to dissipate heat that would otherwise be concentrated in the load zone. This may be achieved (when removing from a furnace) through a reduction in the thermal gradient between the high temperature boat (and wafers) and the faster cooling paddle that supports the boat.

Any combination of the paddle features described herein may be used together in a single paddle. For instance, a paddle may include a 5x5 cm square handle, an internal dam, a channel and a sub-channel in the load zone, one or more windows in the lower wall portion and one or more slots in the upper wall portion. In another example, a paddle may include a load zone having a channel with a flat, extended horizontal surface Any of these features or other features described herein can be added, modified or deleted depending on the specific requirements of a particular paddle.

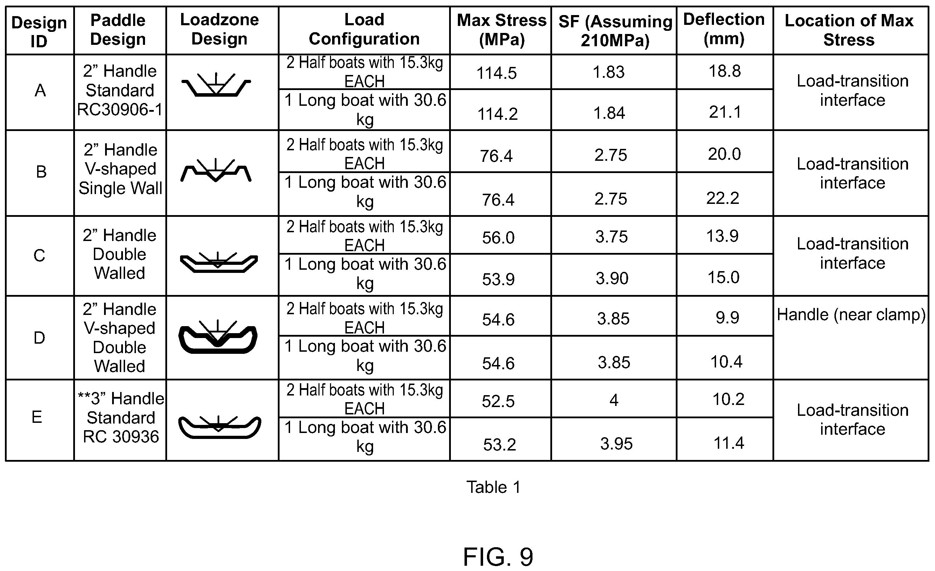

Using finite element analysis (FEA) the design of one of the embodiments described herein was evaluated against known silicon carbide paddles as well as against other design candidates. These results are provided in Table 1 of FIG. 9. All paddles were assumed to be constructed from silicon carbide ceramic such as CRYSTAR brand recrystallized silicon carbide, available from Saint-Gobain Ceramics & Plastics, Inc. This material exhibits a Modulus of Rupture (MOR) of 170 MPa and a Modulus of Elasticity (MOE) of 280 GPa. Each paddle had a handle of 1093 mm of which 520 mm was clamped. The transition zone was 254 mm and the load zone measured 1620 mm in length. Column 1 of Table 1 provides an ID letter for each paddle tested. Each design is described in column 2. Column 3 includes a cross-sectional profile of the load zone of each design. Column 4 describes the load configuration. Each paddle was loaded with 2 half boats of 15.3 kg each and, alternatively, 1 long boat weighing 30.6 kg. In column 5 the maximum stress for each paddle and load condition is calculated. In column 6 the resulting safety factor is provided assuming catastrophic failure at 210 MPa. In column 7 the deflection for each paddle under each load is provided. In column 8 the location of the maximum stress for each paddle is described.

Design A is a five cm handle paddle available from Saint-Gobain Plastics & Ceramics as part number RC30906-1. Design E is a 7.5 cm handle paddle available from Saint-Gobain Plastics & Ceramics as part number RC30936. Design B is a new five cm handle single walled design with a central channel to accommodate a diamond configuration of square wafers. Design C is a new five cm handle double walled design sized to accommodate commercially available boats and furnaces. Design D is a five cm handle double wall design that represents one of the embodiments described herein.

As is evident from Table 1 shown in FIG. 9, when the analysis is completed using two 15.3 kg half boats, the stress results, in general, are close to those obtained for the same paddles when carrying a single 30.6 kg long boat. The maximum stress results for each of designs C, D and E were comparable, resulting in a safety factor (using a MOR of 210 MPa) of about 4 for each of them. However, design D is the only one of these designs that can support a standard boat holding square wafers in a diamond configuration. Furthermore, design D provides the lowest deflection values in the group at less than 10 mm when loaded with two half boats and less than 11 mm when loaded with a single long boat. Of particular interest is the location of maximum stress for design D when compared to the other paddle designs. Calculations show that each of designs A, B, C and E have a location of maximum stress at the junction of the load zone and the transition zone. On the contrary, design D has a location of maximum stress in the handle near the clamping region (520 mm from the proximal end). Therefore the location of maximum stress in paddle designs A, B, C and E is in a region that is subjected to thermal cycling and thermal stress. However, the location of maximum stress in paddle design D is in a region that is subject to significantly less thermal cycling and stress, resulting in greater confidence regarding the long term integrity of the paddle.

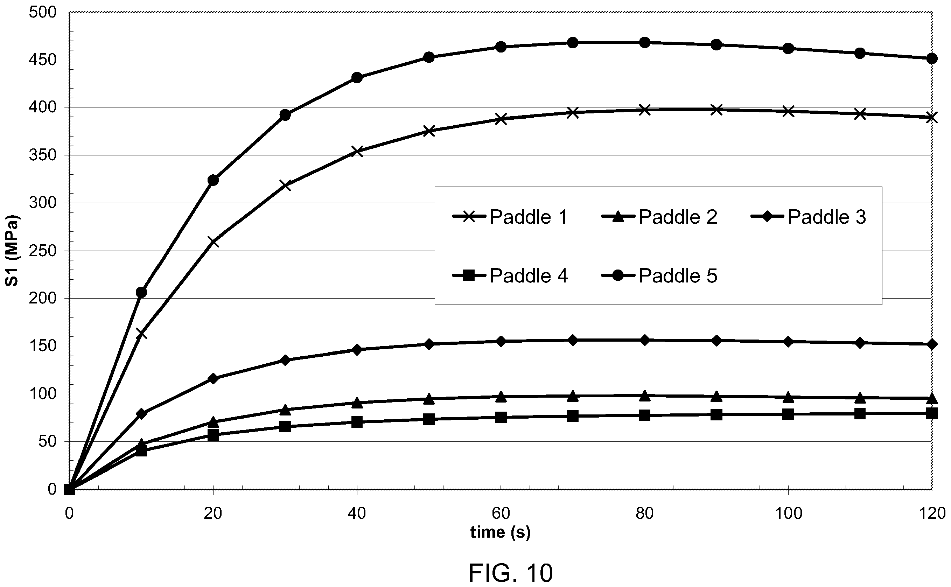

An additional set of FEA evaluations were completed on five different paddle designs to compare the surface stress realized by each design under operating conditions. All were double-walled designs composed of silicon carbide. Paddle 1 included a channel and a v-shaped sub-channel, as shown in FIG. 7. It also included a thermal window centrally located in the lower wall portion of the load zone, the thermal window having dimensions of 25.4 mm wide and 360 mm long with a 12.7 mm radius. Paddle 2 was similar to paddle 1 except that it included a keyhole shaped slot in the V portion of the sub-channel. The slot dimensions were 15 mm by 300 mm with a 25.4 mm diameter hole on the end of the slot closest to the handle. Paddle 3 included a substantially flat channel (no sub-channel, as in FIG. 3b) in the upper wall portion and a thermal window dimensioned as in paddles 1 and 2. Paddle 4 was identical to paddle 3 except that it included a 100 mm extension of the load zone positioned beyond the end of the loaded boat. Paddle 5 was identical to paddle 1 except that it did not include a thermal window. A graph showing the maximum surface stress over time is presented in FIG. 10. These results simulate instantaneous removal (at t=0) from a 750° C furnace. As can be seen from the graph, maximum surface stress is usually realized between about 70 and 90 seconds. The three paddles exhibiting the lowest stress each included thermal windows, and the paddle exhibiting the greatest stress had no thermal window. The paddle including an extended load zone had lower stress than did an equivalent paddle without an extended load zone. The lowest stress paddle included both a thermal window and a load zone extension.

While several embodiments of the present invention have been described and illustrated herein, those of ordinary skill in the art will readily envision a variety of other means and/or structures for performing the functions and/or obtaining the results and/or one or more of the advantages described herein, and each of such variations and/or modifications is deemed to be within the scope of the present invention, which is defined by the appended claims. More generally, those skilled in the art will readily appreciate that all parameters, dimensions, materials, and configurations described herein are meant to be exemplary and that the actual parameters, dimensions, materials, and/or configurations will depend upon the specific application or applications for which the teachings of the present invention is/are used. Those skilled in the art will recognize, or be able to ascertain using no more than routine experimentation, many equivalents to the specific embodiments of the invention described herein. It is, therefore, to be understood that the foregoing embodiments are presented by way of example only.

The indefinite articles "a" and "an," as used herein in the specification and in the claims, unless clearly indicated to the contrary, should be understood to mean "at least one."

The phrase "and/or," as used herein in the specification and in the claims, should be understood to mean "either or both" of the elements so conjoined, i.e., elements that are conjunctively present in some cases and disjunctively present in other cases.

## Claims

1. A cantilever ceramic wafer paddle (100) comprising:
a double-walled load zone (110), wherein, in cross section, the double-walled load zone has a continuous wall surrounding a hollow portion; and
a handle (120),
wherein the double-walled load zone comprises an upper wall portion (124) defining a channel (140), **characterized in that** the channel includes a sub-channel (150).

2. The ceramic wafer paddle according to claim 1, wherein the continuous wall comprises the upper wall portion (124), a lower wall portion (122) and side wall portions (126, 128).

3. The ceramic wafer paddle according to claim 1, wherein the sub-channel increases a depth of the channel, particularly wherein the sub-channel is substantially V-shaped or U-shaped, and more particularly wherein the depth of the channel is greater than or equal to 30% of a height of the double-walled load zone.

4. The ceramic wafer paddle of claim 1 wherein the load zone is comprised of silicon carbide.

5. The ceramic wafer paddle of claim 1 wherein the upper wall portion defines a longitudinal slot (412) passing therethrough.

6. The ceramic wafer paddle of claim 5, wherein the longitudinal slot is formed in the sub-channel.

7. The ceramic wafer paddle of claim 1 comprising a lower wall portion (122) defining at least one thermal window (322, 322a).

8. The ceramic wafer paddle of claim 1 wherein the double-walled load zone comprises a lower wall portion (122) defining at least one thermal window (322, 322a) centrally located along the lower wall portion and in alignment with a longitudinal axis of the ceramic wafer paddle.

9. The ceramic wafer paddle of claim 1, wherein the double-walled load zone includes an extension so that, when the load zone is loaded with wafers or with one or more boats supporting wafers, the distal end of the load zone extends beyond the end of the wafers or the end of the one or more boats by a distance equal to the length of the extension, wherein the extension is greater than or equal to 5 cm or wherein the length of the load zone is extended by more than 5%.

10. A method of processing wafers (240) comprising:
loading greater than 20 kg of wafers onto the ceramic wafer paddle (100) according to any of claims 1 to 9, wherein the ceramic wafer paddle is a silicon carbide wafer paddle;
sliding the ceramic wafer paddle into a furnace tube; and
processing the wafers.

11. The method of claim 10 further comprising loading the wafers onto one or more boats (200) prior to loading the wafers onto the silicon carbide wafer paddle.

12. The method of claim 11 wherein the wafers are loaded onto the one or more boats in a diamond load configuration.

13. The method of claim 10 wherein the wafers are loaded onto the load zone (110) of the ceramic wafer paddle (100) and the load zone is greater than 1000 mm long.

14. The method of claim 10 wherein the wafers are photovoltaic wafers.

15. The method of claim 10, comprising:
removing the loaded ceramic wafer paddle from the furnace at a rate of greater than 300 mm/min wherein the furnace is at a temperature greater than or equal to 700° C.

## Patentansprüche

1. Kragarm-Keramikwafer-Schaufel (100), umfassend:
eine doppelwandige Lastzone (110), wobei, im Querschnitt, die doppelwandige Lastzone eine durchgehende Wand besitzt, die einen hohlen Abschnitt umgibt; und
einen Griff (120),
wobei die doppelwandige Lastzone einen oberen Wandabschnitt (124) umfasst, der einen Kanal (140) definiert, **dadurch gekennzeichnet, dass** der Kanal einen Unterkanal (150) aufweist.

2. Keramikwafer-Schaufel nach Anspruch 1, wobei die kontinuierliche Wand den oberen Wandabschnitt (124), einen unteren Wandabschnitt (122) und seitliche Wandabschnitte (126, 128) umfasst.

3. Keramikwafer-Schaufel nach Anspruch 1, wobei der Unterkanal eine Tiefe des Kanals vergrößert, wobei insbesondere der Unterkanal im Wesentlichen V-förmig oder U-förmig ist, und wobei insbesondere die Tiefe des Kanals größer als oder gleich 30 % einer Höhe der doppelwandigen Lastzone ist.

4. Keramikwafer-Schaufel nach Anspruch 1, wobei die Lastzone aus Siliziumkarbid aufgebaut ist.

5. Keramikwafer-Schaufel nach Anspruch 1, wobei der obere Wandabschnitt einen Längsschlitz (412) definiert, der durch ihn hindurchgeht.

6. Keramikwafer-Schaufel nach Anspruch 5, wobei der Längsschlitz in dem Unterkanal ausgebildet ist.

7. Keramikwafer-Schaufel nach Anspruch 1, umfassend einen unteren Wandabschnitt (122) der mindestens ein thermisches Fenster (322, 322a) definiert.

8. Keramikwafer-Schaufel nach Anspruch 1, wobei die doppelwandige Lastzone einen unteren Wandabschnitt (122) umfasst, der mindestens ein thermisches Fenster (322, 322a) definiert, das mittig entlang des unteren Wandabschnitts und in Ausrichtung mit einer Längsachse der Keramikwafer-Schaufel angeordnet ist.

9. Keramikwafer-Schaufel nach Anspruch 1, wobei die doppelwandige Lastzone eine Erweiterung aufweist, so dass, wenn die Lastzone mit Wafern oder mit einem oder mehreren Booten beladen ist, die Wafer tragen, sich das distale Ende der Lastzone über das Ende der Wafer oder das Ende des einen oder der mehreren Booten hinaus um einen Abstand erstreckt, der gleich der Länge der Erweiterung ist, wobei die Ausdehnung größer als oder gleich 5 cm ist oder wobei die Länge der Lastzone um mehr als 5 % erweitert ist.

10. Verfahren zum Bearbeiten von Wafern (240), umfassend:
Laden von mehr als 20 kg von Wafern auf die Keramikwafer-Schaufel (100) nach einem der Ansprüche 1 bis 9, wobei die Keramikwafer-Schaufel eine Siliziumkarbid-Wafer-Schaufel ist;
Verschieben der Keramikwafer-Schaufel in ein Ofenrohr; und
Bearbeiten der Wafer.

11. Verfahren nach Anspruch 10, ferner umfassend ein Laden der Wafer auf ein oder mehrere Boote (200) vor dem Laden der Wafer auf die Siliziumkarbid - Wafer-Schaufel.

12. Verfahren nach Anspruch 11, wobei die Wafer auf das eine oder die mehreren Boote in einer Diamantlastkonfiguration geladen werden.

13. Verfahren nach Anspruch 10, wobei die Wafer auf die Lastzone (110) der Keramikwafer-Schaufel (100) geladen werden und die Lastzone mehr als 1000 mm lang ist.

14. Verfahren nach Anspruch 10, wobei die Wafer photovoltaische Wafer sind.

15. Verfahren nach Anspruch 10, umfassend:
Entfernen der beladenen Keramikwafer-Schaufel aus dem Ofen mit einer Geschwindigkeit größer als 300 mm/min, wobei der Ofen eine Temperatur von größer als oder gleich 700 °C hat.

## Revendications

1. Palette à tranches en céramique en porte-à-faux (100) comprenant :
une zone de chargement à double paroi (110), dans laquelle, en coupe transversale, la zone de chargement à double paroi a une paroi continue entourant une partie creuse ; et
un manche (120),
dans laquelle la zone de chargement à double paroi comprend une partie de paroi supérieure (124) définissant un canal (140), **caractérisé en ce que** le canal inclut un sous-canal (150).

2. Palette à tranches en céramique selon la revendication 1, dans laquelle la paroi continue comprend la partie de paroi supérieure (124), une partie de paroi inférieure (122) et des parties de paroi latérales (126, 128).

3. Palette à tranches en céramique selon la revendication 1, dans laquelle le sous-canal augmente une profondeur du canal, en particulier dans laquelle le sous-canal est essentiellement en forme de V ou en forme de U, et plus particulièrement dans laquelle la profondeur du canal est supérieure ou égale à 30 % d'une hauteur de la zone de chargement à double paroi.

4. Palette à tranches en céramique selon la revendication 1 dans laquelle la zone de chargement est constituée de carbure de silicium.

5. Palette à tranches en céramique selon la revendication 1 dans laquelle la partie de paroi supérieure définit une encoche longitudinale (412) passant à travers celle-ci.

6. Palette à tranches en céramique selon la revendication 5, dans laquelle l'encoche longitudinale est formée dans le sous-canal.

7. Palette à tranches en céramique selon la revendication 1 comprenant une partie de paroi inférieure (122) définissant au moins une fenêtre thermique (322, 322a).

8. Palette à tranches en céramique selon la revendication 1 dans laquelle la zone de chargement à double paroi comprend une partie de paroi inférieure (122) définissant au moins une fenêtre thermique (322, 322a) centrée le long de la partie de paroi inférieure et en alignement avec un axe longitudinal de la palette à tranches en céramique.

9. Palette à tranches en céramique selon la revendication 1, dans laquelle la zone de chargement à double paroi inclut une extension de sorte que, lorsque la zone de chargement est chargée de tranches ou d'une ou plusieurs nacelles supportant des tranches, l'extrémité distale de la zone de chargement s'étend au-delà de l'extrémité des tranches ou de l'extrémité de la ou des nacelles d'une distance égale à la longueur de l'extension, dans laquelle l'extension est supérieure ou égale à 5 cm ou dans laquelle la longueur de la zone de chargement est étendue de plus de 5 %.

10. Procédé de traitement de tranches (240) comprenant :
le chargement de plus de 20 kg de tranches sur la palette à tranches en céramique (100) selon l'une quelconque des revendications 1 à 9, dans lequel la palette à tranches en céramique est une palette à tranches en carbure de silicium ;
le coulissement de la palette à tranches en céramique dans un tube four ; et
le traitement des tranches.

11. Procédé selon la revendication 10 comprenant en outre le chargement des tranches sur une ou plusieurs nacelles (200) avant le chargement des tranches sur la palette à tranches en carbure de silicium.

12. Procédé selon la revendication 11 dans lequel les tranches sont chargées sur la ou les nacelles dans une configuration de chargement en losange.

13. Procédé selon la revendication 10 dans lequel les tranches sont chargées sur la zone de chargement (110) de la palette à tranches en céramique (100) et la zone de chargement a une longueur supérieure à 1000 mm.

14. Procédé selon la revendication 10 dans lequel les tranches sont des tranches photovoltaïques.

15. Procédé selon la revendication 10, comprenant :
le retrait de la palette à tranches en céramique chargée du four à une vitesse supérieure à 300 mm/min dans lequel le four est à une température supérieure ou égale à 700 °C.
